# EUROPEAN PATENT SPECIFICATION

(11) **EP 3 647 460 B1**
(45) Date of publication and mention of the grant of the patent: **12.04.2023**
(21) Application number: 18823105.4
(22) Date of filing: 17.05.2018
(51) Int. Cl.: C23C 16/32, C23C 16/455

(54) **THIN FILM PRODUCTION METHOD AND NOVEL COMPOUND**
DÜNNSCHICHTHERSTELLUNGSVERFAHREN UND NEUE VERBINDUNG
PROCÉDÉ DE PRODUCTION DE FILMS MINCES ET NOUVEAU COMPOSÉ

(30) Priority: 29.06.2017 JP 2017127401
(43) Date of publication of application: 06.05.2020
(73) Proprietor: Adeka Corporation, Tokyo 116-8554 (JP)
(72) Inventor: NISHIDA, Akihiro, Tokyo 116-8554 (JP); OKADA, Nana, Tokyo 116-8554 (JP); OOE, Yoshiki, Tokyo 116-8554 (JP)
(74) Representative: Kador & Partner Part mbB
(86) International application number: PCT/JP2018/019080
(87) International publication number: WO 2019/003695

(56) References cited:
- JP-A- H06 145 987
- JP-A- H11 172 438
- JP-A- 2000 154 210
- JP-A- 2005 082 539
- JP-A- 2009 545 135
- JP-A- 2014 510 733
- JP-A- 2017 504 657
- US-A1- 2006 257 667
- US-A1- 2014 134 331
- PAQUETTE LEO A. ET AL: "Isodicyclopentadienes and related molecules. 43. Stereochemical course of .pi.-face coordination to isodicyclopentadiene during formation of mixed titanocene and zirconocene dichloride complexes", ORGANOMETALLICS, vol. 8, no. 9, 1 September 1989 (1989-09-01), pages 2159-2167, XP055782543, ISSN: 0276-7333, DOI: 10.1021/om00111a011
- TERPTRA ANDRIES ET AL: "The He(I) and He(II) photoelectron spectra of some [eta]5-cyclopentadienyl-titanium,-zirconiu m and -hafnium trihalide complexes", JOURNAL OF ORGANOMETALLIC CHEMISTRY, vol. 260, no. 2, 1 January 1984 (1984-01-01), pages 207-217, XP055782547, AMSTERDAM, NL ISSN: 0022-328X, DOI: 10.1016/S0022-328X(00)98696-0

## Description

### Technical Field

The present invention relates to the use of a raw material for thin film formation, a method for manufacturing a thin film using the raw material for thin film formation, and a novel compound.

### Background Art

A thin film containing titanium oxide is applied as a gate insulating film in a semiconductor memory material. In addition, thin films containing titanium carbide are used for cutting tools, wiring and electrodes for electronic goods, and for example, applications to semiconductor memory materials and electrodes for lithium-air batteries have been studied.

Examples of a method for manufacturing the above thin film include a sputtering method, an ion plating method, an MOD method such as a coating pyrolysis method and a sol-gel method, and a chemical vapor deposition method (hereinafter simply referred to as a CVD method). However, among the above methods, the CVD method has many advantages such as excelling in composition controllability and stepwise coating ability, being suitable for mass production, and enabling hybrid accumulation. Therefore, a CVD method including an atomic layer deposition (ALD) method is an optimum manufacturing process.

Patent Document 1 and Patent Document 2 disclose Ti(C₅Me₅)(Me)₃ as a raw material for forming titanium-containing thin film by an ALD method (Me represents a methyl group) . However, since Ti(C₅Me₅)(Me)₃ has poor thermal stability, there are problems of residual carbon components as organic substances being mixed into a thin film, and a high quality thin film not being able to form.

In addition, Patent Document 3 discloses MCl₃(R₁R₂R₃R₄R₅Cp) as a zirconium compound or a hafnium compound that can be applied in a CVD method or an ALD method (M represents hafnium or zirconium, R₁ to R₅ represent an alkyl group, and Cp represents a cyclopentadienyl group) . According to Table 1 in Patent Document 3, it is disclosed that, when an alkyl group bonded to a cyclopentadienyl group is an alkyl group having 3 carbon atoms, an isopropyl group gives a lower melting point than an n-propyl group, and in the case of an alkyl group having 4 carbon atoms, a tertiary butyl group gives a lower melting point than an n-butyl group. Therefore, it was found that, among compounds represented by MCl₃(R₁R₂R₃R₄R₅Cₚ), when M is hafnium, a bulky alkyl group bonded to a cyclopentadienyl group tends to give a lower melting point.

In addition, Non-Patent Document 1 and Non-Patent Document 2 disclose tetrakis neopentyl titanium as a titanium source used when a titanium carbide thin film is manufactured by an MOCVD method. However, when a titanium carbide thin film is manufactured using tetrakis neopentyl titanium by an MOCVD method, the concentration of a carbon component in titanium carbide becomes less than a theoretical amount, and it is not possible to manufacture a titanium carbide thin film having high quality. In addition, when a film is attempted to be formed at a high temperature in order to stabilize quality, since tetrakis neopentyl titanium has poor thermal stability, a carbon component of an organic substance is mixed into a thin film, and it is difficult to form a titanium carbide thin film having high quality. Further relevant prior art is disclosed in Patent Documents 4, 5 and Non Patent Documents 3 and 4.

### Citation List

### Patent Documents

[Patent Document 1] Japanese Patent Application Publication No. 2006-310865
[Patent Document 2] Japanese Translation of PCT Application No. 2009-545135
[Patent Document 3] WO 2011/057114
[Patent Document 4] JP 2005 082539 A
[Patent Document 5] US 2014/134331 A1

### Non-Patent Documents

[Non-Patent Document 1] Journal of American Chemical Society. 1987, vol. 109, p. 1579-1580 (USA)
[Non-Patent Document 2] Journal of American Ceramic Society. 2013, vol. 96, No. 4, p. 1060-1062 (USA)
[Non-Patent Document 4] ORGANOMETALLICS, vol. 8, no. 9, 1 September 1989 (1989-09-01), pages 2159-2167, XP055782543,ISSN: 0276-7333, DOI: 10.1021/0m00111a011
[Non Patent Document 5] JOURNAL OF ORGANOMETALLIC CHEMISTRY, vol. 260, no. 2, 1 January 1984 (1984-01-01), pages 207-217, XP055782547, AMSTERDAM, NL ISSN: 0022-328X, DOI: 10.1016/ S0022-328X(00)98696-0

### Summary of Invention

### Technical Problem

Properties required for a method for manufacturing a titanium-atom-containing thin film using a CVD method include being capable of forming a thin film safely with no pyrophoricity in a raw material for thin film formation, using raw materials for thin film formation having a low melting point and being deliverable in a liquid state, the raw materials for thin film formation having favorable thermal decomposability and/or reactivity with a reactive gas, and having excellent productivity. In addition, a small amount of residual carbon components as organic substances being mixed into the obtained titanium-atom-containing thin film and high quality are also required. In the related art, there are no raw materials for thin film formation or methods for manufacturing thin film that are sufficiently satisfactory in these respects.

### Solution to Problem

As a result of repeated examinations, the inventors found that raw materials for thin film formation containing a specific compound, and a method for manufacturing a titanium-atom-containing thin film using the raw materials for thin film formation can address the above problems, and thus developed the present invention. The invention is defined by the appended claims.

The present invention provides the use of raw materials for thin film formation containing a compound represented by the following General Formula (1) and a method for manufacturing a thin film using the raw material.

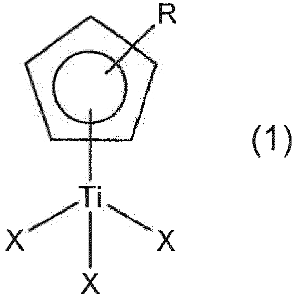

In the formula, X represents a halogen atom, and R represents a primary alkyl group having 1 to 5 carbon atoms or a secondary butyl group.

In addition, the present invention provides a compound represented by the following General Formula (2).

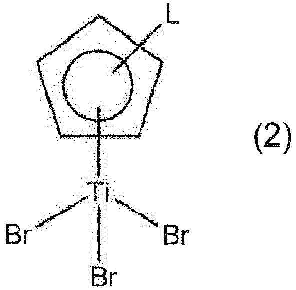

In the formula, L represents a primary alkyl group having 2 to 5 carbon atoms or a secondary butyl group.

### Advantageous Effects of Invention

According to the present invention, it is possible to provide a raw material for thin film formation suitable for chemical vapor deposition used for forming a titanium-atom-containing thin film having a low melting point that becomes a liquid at 30°C or by being slightly heated under atmospheric pressure. In addition, it is possible to safely manufacture a high quality titanium-atom-containing thin film having excellent productivity and containing little residual carbon components as organic substances mixed thereinto.

### Brief Description of Drawings

Fig. 1 is a schematic diagram showing an example of a chemical vapor deposition apparatus used in a method for manufacturing a titanium-atom-containing thin film according to the present invention.
Fig. 2 is a schematic diagram showing another example of a chemical vapor deposition apparatus used in a method for manufacturing a titanium-atom-containing thin film according to the present invention.
Fig. 3 is a schematic diagram showing another example of a chemical vapor deposition apparatus used in a method for manufacturing a titanium-atom-containing thin film according to the present invention.
Fig. 4 is a schematic diagram showing another example of a chemical vapor deposition apparatus used in a method for manufacturing a titanium-atom-containing thin film according to the present invention.

### Description of Embodiments

Raw materials for thin film formation of the present invention are those containing the compound represented by General Formula (1), and are suitable as precursors for a method for manufacturing thin film comprising a vaporization step such as a CVD method, and a thin film can be formed using an ALD method therewith.

In General Formula (1), X represents a halogen atom. Examples of halogen atoms include a fluorine atom, a chlorine atom, and a bromine atom. X is preferably a chlorine atom or a bromine atom since a strong effect of manufacturing a titanium-atom-containing thin film containing little residual carbon components as organic substances mixed thereinto is obtained.

In addition, in General Formula (1), R represents a primary alkyl group having 1 to 5 carbon atoms or a secondary butyl group. Examples of primary alkyl groups having 1 to 5 carbon atoms include a methyl group, an ethyl group, an n-propyl group, an n-butyl group, and an n-pentyl group.

In General Formula (1), when X is a chlorine atom, R is preferably a secondary butyl group or a primary alkyl group having 3 to 5 carbon atoms since the melting point is low. Among these, a secondary butyl group, an n-propyl group or an n-butyl group is more preferable, and a secondary butyl group or an n-butyl group is particularly preferable.

In General Formula (1), when X is a bromine atom, R is preferably a secondary butyl group or a primary alkyl group having 2 to 4 carbon atoms since the melting point is low. Among these, R is preferably a secondary butyl group or an ethyl group since the vapor pressure is high, and R is preferably an ethyl group since the melting point is particularly low.

Preferable specific examples of the compound represented by General Formula (1) include, for example, compounds represented by the following Compounds No. 1 to No. 12. Here, in the following Compounds No. 1 to No. 12, "Me" represents a methyl group, "Et" represents an ethyl group, "Pr" represents an n-propyl group, "Bu" represents an n-butyl group, "sBu" represents a secondary butyl group, and "Am" represents an n-pentyl group.

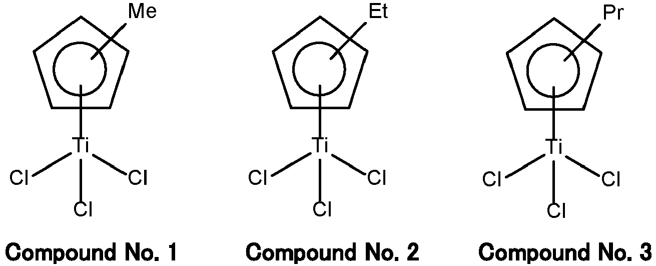

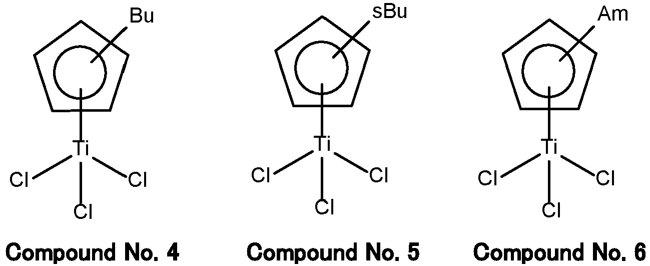

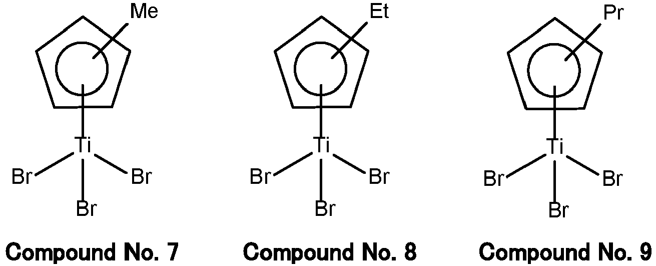

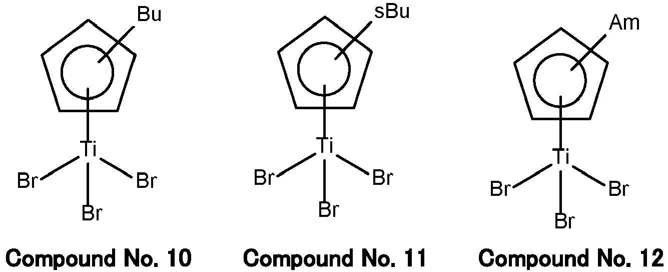

The compound represented by General Formula (1) is not particularly limited by the method for manufacturing and can be manufactured by applying a known reaction. Regarding a method for manufacturing, for example, when X is a chlorine atom and R is an ethyl group, the compound can be obtained by reacting titanium tetrachloride with trimethyl(3-ethyl-2,4-cyclopentadien-1-yl) silane at room temperature, and performing distillation and purification. When X is a chlorine atom and R is an n-propyl group, the compound can be obtained by reacting titanium tetrachloride with trimethyl(3-propyl-2,4-cyclopentadien-1-yl) silane at room temperature, and performing distillation and purification. When X is a chlorine atom and R is an n-butyl group, the compound can be obtained by reacting titanium tetrachloride with trimethyl(3-butyl-2,4-cyclopentadien-1-yl) silane at room temperature, and performing distillation and purification. In the above method, it is possible to manufacture a compound in which X is a bromine atom by replacing titanium tetrachloride with titanium tetrabromide.

The raw materials for thin film formation of the present invention contain compounds represented by General Formula (1) as precursors for a CVD method for forming a titanium-atom-containing thin film and their forms vary depending on a manufacturing process in which the raw materials for thin film formation are applied. For example, when a titanium-atom-containing thin film is manufactured, the raw materials for thin film formation of the present invention do not contain metal compounds or semi-metal compounds other than the compounds represented by General Formula (1). On the other hand, when a thin film containing a metal and/or semi-metal other than a titanium atom, and titanium atoms is manufactured, the raw materials for thin film formation of the present invention contain, in addition to the compound represented by General Formula (1), a compound containing a metal and/or a compound containing a semi-metal other than a titanium atom (hereinafter referred to as other precursors). As will be described below, the raw materials for thin film formation of the present invention may further contain an organic solvent and/or a nucleophilic reagent. The raw material for thin film formation of the present invention is particularly useful as a raw material for chemical vapor deposition (hereinafter referred to as a raw material for CVD) since, as described above, physical properties of the compound represented by General Formula (1) as a precursor are suitable for a CVD method and an ALD method.

The forms of the raw materials for thin film formation of the present invention are appropriately selected according to a method such as a delivery and feed method of a CVD method used.

Regarding the delivery and feed method, a gas delivery method in which a raw material for CVD is vaporized into a vapor by being heated and/or depressurized in a container in which the raw material is stored (hereinafter simply referred to as a raw material container), and the vapor is introduced into a film formation chamber in which a substrate is disposed together with a carrier gas such as argon, nitrogen, and helium used as necessary may be exemplified. In addition, a liquid delivery method in which a raw material for CVD in a liquid or solution state is deliveried to a vaporization chamber and is vaporized into a vapor by being heated and/or depressurized in the vaporization chamber, and the vapor is introduced into a film formation chamber may be used. In the case of the gas delivery method, the compound represented by General Formula (1) can be directly used as a raw material for CVD. In the case of the liquid delivery method, the compound itself represented by General Formula (1) or a solution in which the compound is dissolved in an organic solvent can be used as a raw material for CVD. Such a raw material for CVD may further contain other precursors, a nucleophilic reagent, and the like.

In addition, in a CVD method of a multicomponent system, a method in which components in a raw material for CVD are independently vaporized and supplied (hereinafter referred to as a single source method) and a method in which mixed raw materials in which multiple component raw materials are mixed in a desired composition in advance, vaporized and fed (hereinafter referred to as a cocktail source method) are used. In the case of the cocktail source method, a mixture containing the compound represented by General Formula (1) and other precursors or a mixed solution in which the mixture is dissolved in an organic solvent can be used as a raw material for CVD. The mixture or mixed solution may further contain a nucleophilic reagent and the like.

Regarding the organic solvent, a generally known organic solvent can be used without any particular limitation. Examples of organic solvents include alcohols such as methanol, ethanol, isopropyl alcohol, and n-butanol; acetate esters such as ethyl acetate, butyl acetate, and methoxyethyl acetate; ethers such as tetrahydrofuran, tetrahydropyran, ethylene glycol dimethyl ether, diethylene glycol dimethyl ether, triethylene glycol dimethyl ether, dibutyl ether, and dioxane; ketones such as methyl butyl ketone, methyl isobutyl ketone, ethyl butyl ketone, dipropyl ketone, diisobutyl ketone, methyl amyl ketone, cyclohexanone, and methylcyclohexanone; hydrocarbons such as hexane, cyclohexane, methylcyclohexane, dimethylcyclohexane, ethylcyclohexane, heptane, octane, toluene, and xylene; hydrocarbons having a cyano group such as 1-cyanopropane, 1-cyanobutane, 1-cyanohexane, cyanocyclohexane, cyanobenzene, 1,3-dicyanopropane, 1,4-dicyanobutane, 1,6-dicyanohexane, 1,4-dicyanocyclohexane, and 1,4-dicyanobenzene; pyridine, lutidine, and the like. These organic solvents may be used alone or two or more types thereof may be used in combination depending on the solubility of a solute, the relationships between an operation temperature, a boiling point, a flash point, and the like. When such an organic solvent is used, preferably, a total amount of the precursors in a raw material for CVD, which is a solution in which the precursors are dissolved in the organic solvent, is 0.01 mol/L to 2.0 mol/L, and particularly 0. 05 mol/L to 1.0 mol/L. When raw materials for thin film formation of the present invention do not contain metal compounds or semi-metal compounds other than the compounds represented by General Formula (1), a total amount of the precursors is an amount of the compound represented by General Formula (1), and when the raw materials for thin film formation of the present invention contain metal-containing compounds and/or semi-metal-containing compounds (other precursors) other than the compounds represented by General Formula (1), a total amount of the precursors is a total amount of the compound represented by General Formula (1) and other precursors.

In addition, in the case of the CVD method of multicomponent system, regarding other precursors to be used together with the compound represented by General Formula (1), a generally known precursor used in a raw material for CVD can be used without any particular limitation. A ligand used in the precursor containing no oxygen atoms in its structure is particularly preferable since an amount of oxygen mixed into the obtained titanium-atom-containing thin film can be reduced.

Regarding other precursors, compounds including one, two or more selected from the group consisting of compounds used as organic ligands such as an alcohol compound, a glycol compound, a β-diketone compound, a cyclopentadiene compound, and an organic amine compound, with silicon or a metal (provided that titanium is excluded) may be exemplified. In addition, examples of the type of a metal of the precursor include magnesium, calcium, strontium, barium, vanadium, niobium, tantalum, aluminum, manganese, iron, ruthenium, cobalt, rhodium, iridium, nickel, palladium, platinum, copper, silver, gold, zinc, zirconium, hafnium, gallium, indium, germanium, tin, lead, antimony, bismuth, scandium, yttrium, lanthanum, cerium, praseodymium, neodymium, promethium, samarium, europium, gadolinium, terbium, dysprosium, holmium, erbium, thulium, ytterbium, and lutetium.

Examples of an alcohol compound used as an organic ligand for other precursors include alkyl alcohols such as methanol, ethanol, propanol, isopropyl alcohol, butanol, secondary butyl alcohol, isobutyl alcohol, tertiary butyl alcohol, pentyl alcohol, isopentyl alcohol, and tertiary pentyl alcohol; and ether alcohols such as 2-methoxyethanol, 2-ethoxyethanol, 2-butoxyethanol, 2-(2-methoxyethoxy)ethanol, 2-methoxy-1-methylethanol, 2-methoxy-1,1-dimethylethanol, 2-ethoxy-1,1-dimethylethanol, 2-isopropoxy-1,1-dimethylethanol, 2-butoxy-1,1-dimethylethanol, 2-(2-methoxyethoxy)-1,1-dimethylethanol, 2-propoxy-1,1-diethylethanol, 2-s-butoxy-1,1-diethylethanol, and 3-methoxy-1,1-dimethylpropanol.

Examples of a glycol compound used as an organic ligand for other precursors include 1,2-ethanediol, 1,2-propanediol, 1,3-propanediol, 2,4-hexanediol, 2,2-dimethyl-1,3-propanediol, 2,2-diethyl-1,3-propanediol, 1,3-butanediol, 2,4-butanediol, 2,2-diethyl-1,3-butanediol, 2-ethyl-2-butyl-1,3-propanediol, 2,4-pentanediol, 2-methyl-1,3-propanediol, 2-methyl-2,4-pentanediol, 2,4-hexanediol, and 2,4-dimethyl-2,4-pentanediol.

In addition, examples of β-diketone compounds include alkyl-substituted β-diketones such as acetylacetone, hexane-2,4-dione, 5-methylhexane-2,4-dione, heptane-2,4-dione, 2-methylheptane-3,5-dione, 5-methylheptane-2,4-dione, 6-methylheptane-2,4-dione, 2,2-dimethylheptane-3,5-dione, 2,6-dimethylheptane-3,5-dione, 2,2,6-trimethylheptane-3,5-dione, 2,2,6,6-tetramethylheptane-3,5-dione, octane-2,4-dione, 2,2,6-trimethyloctane-3,5-dione, 2,6-dimethyloctane-3,5-dione, 2,9-dimethylnonane-4,6-dione, 2-methyl-6-ethyldecane-3,5-dione, and 2,2-dimethyl-6-ethyldecane-3,5-dione; fluorine-substituted alkyl β-diketones such as 1,1,1-trifluoropentane-2,4-dione, 1,1,1-trifluoro-5,5-dimethylhexane-2,4-dione, 1,1,1,5,5,5-hexafluoropentane-2,4-dione, and 1,3-diperfluorohexylpropane-1,3-dione; and ether-substituted β-diketones such as 1,1,5,5-tetramethyl-1-methoxyhexane-2,4-dione, 2,2,6,6-tetramethyl-1-methoxyheptane-3,5-dione, and 2,2,6,6-tetramethyl-1-(2-methoxyethoxy)heptane-3,5-dione.

In addition, examples of cyclopentadiene compounds include cyclopentadiene, methylcyclopentadiene, ethylcyclopentadiene, propylcyclopentadiene, isopropylcyclopentadiene, butylcyclopentadiene, secondary butylcyclopentadiene, isobutylcyclopentadiene, tertiary butylcyclopentadiene, dimethylcyclopentadiene, and tetramethylcyclopentadiene. In addition, examples of an organic amine compound used as the organic ligand include methylamine, ethylamine, propylamine, isopropylamine, butylamine, secondary butylamine, tertiary butylamine, isobutylamine, dimethylamine, diethylamine, dipropylamine, diisopropylamine, ethylmethylamine, propylmethylamine, and isopropylmethylamine.

Other precursors are known in the related technical art and methods for manufacturing the same are also known. Regarding a method for manufacturing, for example, when an alcohol compound is used as an organic ligand, an inorganic salt of a metal or its hydrates described above is reacted with an alkali metal alkoxide of the alcohol compound, and thereby a precursor can be manufactured. Here, examples of an inorganic salt of a metal or its hydrates include metal halides and nitrates, and examples of alkali metal alkoxides include sodium alkoxides, lithium alkoxides, and potassium alkoxides.

In the case of a single source method, other precursors are preferably compounds having a similar thermal and/or oxidative decomposition behavior to the compound represented by General Formula (1). In addition, in the case of a cocktail source method, a compound which has a similar thermal and/or oxidative decomposition behavior and also does not cause deterioration due to a chemical reaction during mixing is preferable.

In addition, raw materials for thin film formation of the present invention may contain, as necessary, a nucleophilic reagent for imparting stability to the raw material. Examples of the nucleophilic reagent include ethylene glycol ethers such as glyme, diglyme, triglyme, and tetraglyme, crown ethers such as 18-crown-6, dicyclohexyl-18-crown-6, 24-crown-8, dicyclohexyl-24-crown-8, and dibenzo-24-crown-8, polyamines such as ethylenediamine, N,N'-tetramethylethylenediamine, diethylenetriamine, triethylenetetramine, tetraethylenepentamine, pentaethylenehexamine, 1,1,4,7,7-pentamethyldiethylenetriamine, 1,1,4,7,10,10-hexamethyltriethylenetetramine, and triethoxytriethyleneamine, cyclic polyamines such as cyclam and cyclen, heterocyclic compounds such as pyridine, pyrrolidine, piperidine, morpholine, N-methylpyrrolidine, N-methylpiperidine, N-methylmorpholine, tetrahydrofuran, tetrahydropyran, 1,4-dioxane, oxazole, thiazole, and oxathiolane, β-ketoesters such as methyl acetoacetate, ethyl acetoacetate, and 2-methoxyethyl acetoacetate, and β-diketones such as acetylacetone, 2,4-hexanedione, 2,4-heptanedione, 3,5-heptanedione, and dipivaloylmethane. An amount of such a nucleophilic reagent used is preferably in a range of 0.1 mol to 10 mol and more preferably in a range of 1 mol to 4 mol with respect to 1 mol of the compound represented by General Formula (1). In addition, when such a nucleophilic reagent is used, a nucleophilic reagent having a structure containing no oxygen atoms is preferable, and a nucleophilic reagent having a structure containing a nitrogen atom is particularly preferable.

In the raw materials for thin film formation of the present invention, an impurity metal element content, an impurity halogen content such as impurity chlorine, and impurity organic content other than components constituting the same are minimized. The impurity metal element content is preferably 100 ppb or less and more preferably 10 ppb or less for each element, and a total amount thereof is preferably 1 ppm or less and more preferably 100 ppb or less. In particular, when it is used as a gate insulating film, a gate film, or a barrier layer of an LSI, it is necessary to reduce the content of alkali metal elements, alkaline earth metal elements, and analogous elements which affect electrical characteristics of the obtained thin film. The impurity halogen content is preferably 100 ppm or less, more preferably 10 ppm or less, and most preferably 1 ppm or less. A total amount of the impurity organic content is preferably 500 ppm or less, more preferably 50 ppm or less, and most preferably 10 ppm or less. In addition, since water causes generation of particles in the raw material for CVD and generation of particles during thin film formation, in order to reduce an amount of water in each of the precursor, the organic solvent, and the nucleophilic reagent, it is preferable to remove as much water as possible in advance during use. The content of water in each of the precursor, the organic solvent, and the nucleophilic reagent is preferably 10 ppm or less and more preferably 1 ppm or less.

In addition, in the raw materials for thin film formation of the present invention, in order to reduce or prevent particle contaminants in the formed thin film, it is preferable that as few particles as possible be contained. Specifically, in measurement of particles by a particle detector in a light scattering liquid in a liquid phase, the number of particles larger than 0.3 um is preferably 100 or less in 1 ml of a liquid phase, the number of particles larger than 0.2 um is more preferably 1,000 or less in 1 ml of a liquid phase, and the number of particles larger than 0.2 um is most preferably 100 or less in 1 ml of a liquid phase.

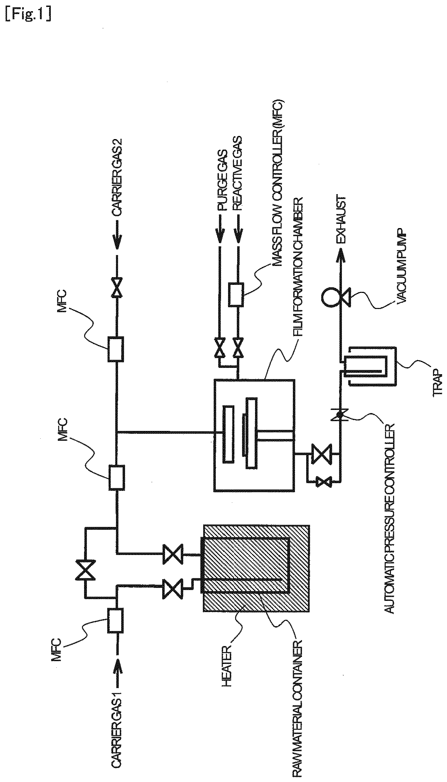

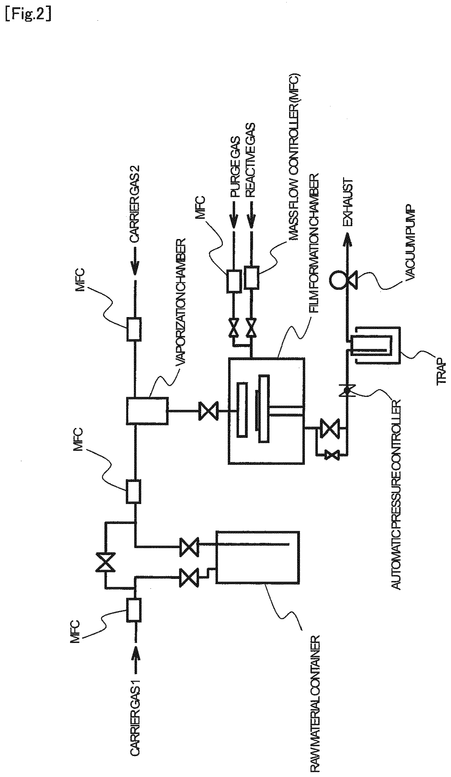

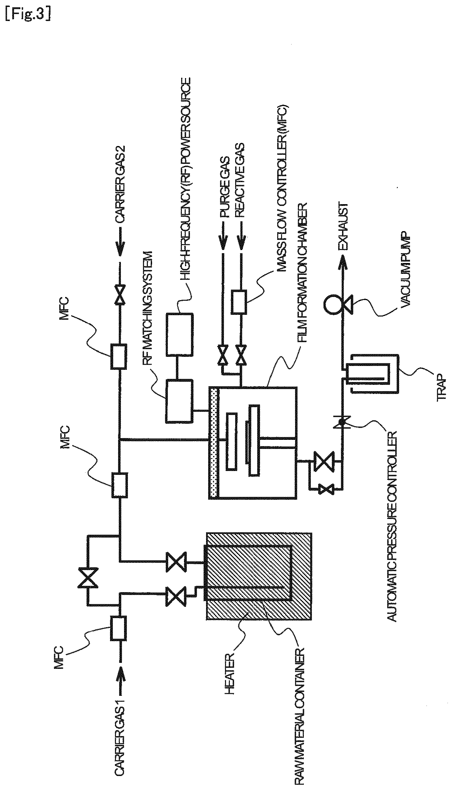

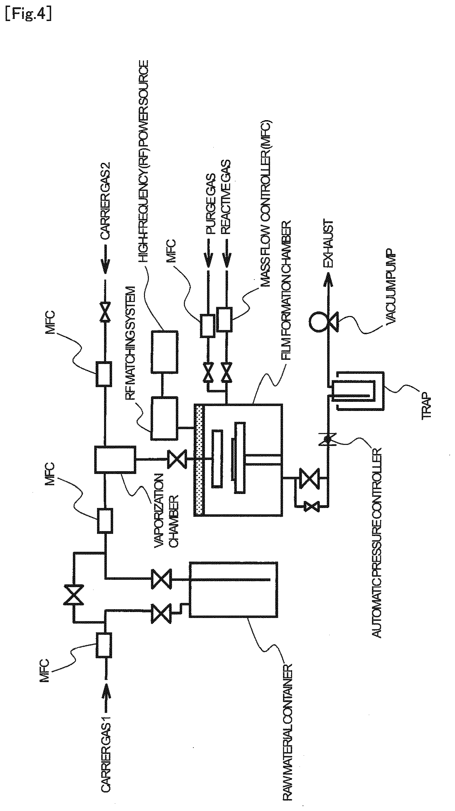

Regarding an apparatus for manufacturing a titanium-atom-containing thin film using the raw materials for thin film formation of the present invention, a known apparatus for a chemical vapor deposition method can be used. Specific examples of apparatuses include an apparatus that can perform bubbling supply of a precursor as shown in Fig. 1 and an apparatus having a vaporization chamber as shown in Fig. 2. In addition, an apparatus that can perform a plasma treatment on a reactive gas as shown in Fig. 3 and Fig. 4 may be exemplified. An apparatus that can simultaneously process a plurality of wafers using a batch furnace can be used without there being limitation to a single-wafer type apparatus as shown in Fig. 1, Fig. 2, Fig. 3, and Fig. 4.

A titanium-atom-containing thin film manufactured using the raw materials for thin film formation of the present invention is used for a cutting tool, and wiring and electrodes for electronic goods, and can be used for, for example, a semiconductor memory material and an electrode for a lithium-air battery.

The method of manufacturing a thin film of the present invention is a CVD method in which vapor obtained by vaporizing the compound represented by General Formula (1), and a reactive gas used as necessary are introduced into a film formation chamber in which a substrate is disposed, and next, a precursor decomposes and/or is chemically reacted, on the substrate and/or in the film formation chamber and/or near a gas inlet and a titanium-atom-containing thin film grows and is deposited on the surface of the substrate. Regarding a raw material delivery and feed method, a deposition method, manufacturing conditions, a manufacturing apparatus, and the like, generally known conditions and methods can be used without any particular limitation.

Examples of reactive gases used as necessary include oxygen, ozone, nitrogen dioxide, nitric oxide, water vapor, hydrogen peroxide, formic acid, acetic acid, and acetic anhydride which have oxidizability, and hydrogen, silane compounds such as monosilane and disilane, boron compounds such as diborane, and phosphorus compounds such as phosphine which have reducibility. In addition, examples of reactive gases that can produce a nitride include organic amine compounds such as monoalkylamines, dialkylamines, trialkylamines, and alkylenediamines, hydrazine, and ammonia, and these can be used alone or two or more types thereof can be used in combination. In addition, the reactive gas can be subjected to a plasma treatment before it reacts with a precursor.

In addition, examples of delivery and feed methods include the gas delivery method, liquid delivery method, single source method, and cocktail source method described above.

In addition, examples of the above deposition methods include thermal CVD in which a thin film is deposited by reacting a raw material gas or a raw material gas and a reactive gas only by heating, plasma CVD using heat and plasma, photo CVD using heat and light, light plasma CVD using heat, light and plasma, and ALD in which a CVD deposition reaction is divided into elementary processes and stepwise deposition is performed at the molecular level.

Examples of materials of the above substrate include silicon; ceramics such as indium arsenide, indium gallium arsenide, silicon oxide, silicon nitride, silicon carbide, titanium nitride, tantalum oxide, tantalum nitride, titanium oxide, titanium nitride, ruthenium oxide, zirconium oxide, hafnium oxide, lanthanum oxide, and gallium nitride; glass; and metals such as platinum, ruthenium, aluminum, copper, nickel, cobalt, tungsten, and molybdenum. Examples of the form of the substrate include a plate shape, a spherical shape, a fibrous form, and a scaly shape. The surface of the substrate may be flat or may have a 3D structure such as a trench structure.

In addition, the above manufacturing conditions include a reaction temperature (substrate temperature), a reaction pressure, a deposition rate, and the like. The reaction temperature is preferably 100°C or higher which is a temperature at which the compound represented by General Formula (1) sufficiently reacts, and more preferably 150°C to 400°C. In addition, the reaction pressure is preferably 10 Pa to atmospheric pressure in the case of thermal CVD or photo CVD, and is preferably 10 Pa to 2,000 Pa when a plasma is used. In addition, the deposition rate can be controlled according to raw material feed conditions (vaporization temperature, vaporization pressure), the reaction temperature, and the reaction pressure. The deposition rate is preferably 0.01 nm/min to 100 nm/min and more preferably 1 nm/min to 50 nm/min since characteristics of the obtained thin film may deteriorate if the deposition rate is high and problems may occur in productivity if the deposition rate is low. In addition, in the ALD method, the number of cycles is controlled to obtain a desired film thickness.

The above manufacturing conditions further include a temperature and pressure at which the raw material for thin film formation is vaporized into a vapor. A step of vaporizing the raw material for thin film formation into a vapor may be performed in the raw material container or in the vaporization chamber. In any case, the raw material for thin film formation used in the method for manufacturing a thin film of the present invention is preferably evaporated at 0°C to 150°C. In addition, when the raw material for thin film formation is vaporized into a vapor in the raw material container or in the vaporization chamber, the pressure in the raw material container and the pressure in the vaporization chamber are both preferably 1 Pa to 10,000 Pa.

The method for manufacturing a thin film of the present invention adopts the ALD method, and may include, in addition to a step for introducing raw material in which a raw material for thin formation is vaporized into a vapor and the vapor is introduced into a film formation chamber according to the delivery and feed method, a step for forming precursor thin film in which a precursor thin film is formed on the surface of the substrate using the compound represented by General Formula (1) in the vapor, an exhaust step in which unreacted compound (represented by General Formula (1)) gases are exhausted, and a titanium-atom-containing thin film forming step in which the precursor thin film is chemically reacted with a reactive gas to form a titanium-atom-containing thin film on the surface of the substrate.

Hereinafter, the above steps will be described in detail using a case in which a titanium-atom-containing thin film is formed by the ALD method as an example. When a titanium-atom-containing thin film is formed by the ALD method, first, the raw material introducing step described above is performed. A preferable temperature and pressure when the raw material for thin film formation is vaporized into a vapor are the same as those described above. Next, a precursor thin film is formed on the surfaces of the substrate using the compound represented by General Formula (1) introduced into the film formation chamber (step for forming precursor thin film). In this case, the substrate may be heated or the film formation chamber may be heated to apply heat.

The precursor thin film formed in this step is a thin film formed by adsorbing the compound represented by General Formula (1) on the surface of the substrate or formed by decomposition and/or reaction of the compound or a part of the compound, and has a composition different from a desired titanium-atom-containing thin film. The temperature of the substrate when this step is performed is preferably room temperature to 600°C and more preferably 150°C to 400°C. The pressure in the system (in the film formation chamber) when this step is performed is preferably 1 Pa to 10,000 Pa and more preferably 10 Pa to 1,000 Pa.

Next, unreacted compound (represented by General Formula (1)) gases and by-product gases are exhausted from the film formation chamber (exhaust step). Unreacted compound gases represented by General Formula (1) and by-product gases should ideally be completely exhausted from the film formation chamber, but they are not necessarily completely exhausted. Examples of an exhaust method include a method for purging the inside of the system with an inert gas such as nitrogen, helium, and argon, a method for exhausting by reducing the pressure in the system, and a combination method thereof. When the pressure is reduced, the degree of pressure reduction is preferably 0.01 Pa to 300 Pa, and more preferably 0.01 Pa to 100 Pa.

Next, a reactive gas is introduced into the film formation chamber, and a titanium-atom-containing thin film is formed from the precursor thin film obtained in the step for forming the previous precursor thin film by the action of the reactive gas or the action of the reactive gas and heat (step for forming titanium-atom-containing thin film) . The temperature when heat is applied in this step is preferably room temperature to 600°C and more preferably 150°C to 400°C. The pressure in the system (in the film formation chamber) when this step is performed is preferably 1 Pa to 10,000 Pa and more preferably 10 Pa to 1,000 Pa.

In the method for manufacturing a thin film of the present invention, when the above ALD method is used, thin film deposition according to a series of operations including the above raw material introducing step, precursor thin film forming step, exhaust step, and step for forming titanium-atom-containing thin film is set as one cycle, and this cycle may be repeated a plurality of times until a thin film with a required film thickness is obtained. In this case, after one cycle is performed, in the same manner as in the exhaust step, preferably unreacted compound (represented by General Formula (1)) gases and a reactive gas, and additionally by-product gases are exhausted from the film formation chamber, and the next one cycle is then performed.

In addition, in the method for manufacturing a thin film of the present invention, when the above ALD method is used, energy such as in plasma, light, and voltage may be applied or a catalyst may be used. A time for which the energy is applied is not particularly limited, and the time may be, for example, during introducing a compound gas in the step for introducing raw material, during heating in the step for forming a precursor thin film or in the step for forming titanium-atom-containing thin film, during exhausting in the system in the exhaust step, during introduction of a reactive gas in the step for forming titanium-atom-containing thin film, or may be between the steps. In addition, such energy can be applied to a reactive gas before the reactive gas is introduced.

In addition, in the method for manufacturing a thin film of the present invention, when the plasma ALD method is used as above, the reactive gas may continue to flow into the film formation chamber during all steps in the manufacturing method, or a reactive gas treated with plasma may be introduced into the film formation chamber only in the step for forming a titanium-atom-containing thin film. If the high frequency (hereinafter referred to as an RF) output is too low, it is difficult to form a favorable film containing titanium atoms, and if the high frequency output is too high, damage to the substrate is too large. Therefore, the output is preferably 0 to 1,500 W and more preferably 50 W to 600 W. In the manufacturing method of the present invention, a plasma ALD method is preferably used since a titanium-atom-containing thin film with very high quality can be obtained.

In addition, in the method for manufacturing a thin film of the present invention, after thin film deposition, in order to obtain more favorable electrical characteristics, an annealing treatment may be performed under an inert atmosphere, or a reflow step may be provided when step coverage is necessary. The temperature in this case is 200°C to 1,000°C and preferably 250°C to 500°C.

Here, among the above raw materials for thin film formation, the compound represented by General Formula (2) is novel as a compound. The novel compound of the present invention has a low melting point, and can be applied in an ALD method, and is a compound particularly suitable as a precursor for a method for manufacturing thin film including a vaporization step such as the CVD method.

In General Formula (2), L represents a primary alkyl group having 2 to 5 carbon atoms or a secondary butyl group. Examples of a primary alkyl group having 2 to 5 carbon atoms include an ethyl group, an n-propyl group, an n-butyl group, and an n-pentyl group.

In General Formula (2), L is preferably an ethyl group since the melting point is particularly low.

The compound represented by General Formula (2) is not particularly limited by the method for manufacturing and is manufactured by applying a known reaction. Regarding a manufacturing method, for example, when L is an ethyl group, the compound can be obtained by reacting titanium tetrabromide with trimethyl(3-ethyl-2,4-cyclopentadien-1-yl) silane at room temperature, and performing distillation and purification. When L is a propyl group, the compound can be obtained by reacting titanium tetrabromide with trimethyl(3-propyl-2,4-cyclopentadien-1-yl) silane at room temperature and performing distillation and purification. When L is a butyl group, the compound can be obtained by reacting titanium tetrabromide with trimethyl(3-butyl-2,4-cyclopentadien-1-yl) silane at room temperature and performing distillation and purification.

Specific examples of the novel compound represented by General Formula (2) include, for example, compounds represented as Compounds Nos. 8 to 12.

### Examples

The present invention will be described below in more detail with reference to examples and evaluation examples. However, the present invention is not limited to the following examples and the like.

### [Manufacturing Example 1] Synthesis of Compound No. 3

36.80 g of titanium tetrachloride and 268.13 g of dehydrated toluene were put into a 1,000 mL 4-neck flask under an Ar atmosphere and sufficiently mixed. This liquid mixture was cooled to 10°C and then trimethyl(3-propyl-2,4-cyclopentadien-1-yl)silane was added dropwise to the stirring liquid mixture. After stirring at room temperature overnight, the solvent was removed in an oil bath at 65°C under a reduced pressure. The flask containing the produced titanium complex was connected to a distillation and purification apparatus, distillation and purification were performed in an oil bath at 145°C and 7 Pa, and thereby 36.36 g of Compound No. 3 as a red-orange solid was obtained. The melting point of the compound was 49°C.

### (Analytical Data)

(1) Atmospheric pressure TG-DTA (quartz pan)
   Temperature of 50% mass reduction: 242°C (Ar flow rate: 100 mL/min, temperature increase rate: 10°C/min, sample amount: 9.552 mg)
(2) Reduced pressure TG-DTA (quartz pan)
   Temperature of 50% mass reduction: 152°C (Ar flow rate: 50 mL/min, temperature increase rate: 10°C/min, sample amount: 9.960 mg)
(3) 1H-NMR (C6D6)
   0.596 ppm (t, 3 H), 1.154 ppm (m, 2 H), 2.296 ppm (t, 2 H), 5.991 ppm (m, 4 H)
(4) Elemental analysis (metal analysis: ICP-AES, CHN analysis: CHN analyzing device, chlorine analysis: TOX analyzing device)
   Ti: 18.3 mass%, C: 36.8 mass%, H: 4.0 mass%, Cl: 40.8 mass% (theoretical values; Ti: 18.31 mass%, C: 36.76 mass%, H: 4.24mass%, Cl: 40.69 mass%)

### [Manufacturing Example 2] Synthesis of Compound No. 4

35.77 g of titanium tetrachloride and 246.54 g of dehydrated toluene were put into a 500 mL 4-neck flask under an Ar atmosphere and sufficiently mixed. This liquid mixture was cooled to 10°C and then trimethyl(3-butyl-2,4-cyclopentadien-1-yl)silane was added dropwise to the stirring liquid mixture. After stirring at room temperature overnight, the solvent was removed in an oil bath at 89°C under a reduced pressure. The flask containing the produced titanium complex was connected to a distillation and purification apparatus, distillation and purification were performed in an oil bath at 136°C and 12 Pa, and thereby 44.09 g of Compound No. 4 as a red-orange liquid was obtained.

### (Analytical Data)

(1) Atmospheric pressure TG-DTA (quartz pan)
   Temperature of 50% mass reduction: 250°C (Ar flow rate: 100 mL/min, temperature increase rate: 10°C/min, sample amount: 9.919 mg)
(2) Reduced pressure TG-DTA (quartz pan)
   Temperature of 50% mass reduction: 159°C (Ar flow rate: 50 mL/min, temperature increase rate: 10°C/min, sample amount: 9.917 mg)
(3) 1H-NMR (C6D6)
   0.744 ppm (t, 3 H), 1.029 ppm (m, 2 H), 1.188 ppm (m, 2 H), 2.400 ppm (t, 2 H), 6.092 ppm (m, 4 H)
(4) Elemental analysis (metal analysis: ICP-AES, CHN analysis: CHN analyzing device, chlorine analysis: TOX analyzing device)
   Ti: 17.2 mass%, C: 39.5 mass%, H: 4.5 mass%, Cl: 38.3 mass% (theoretical values; Ti: 17.38 mass%, C: 39.25mass%, H: 4.76mass%, Cl: 38.61 mass%)

### [Manufacturing Example 3] Synthesis of Compound No. 5

9.76 g of titanium tetrachloride and 71.09 g of dehydrated toluene were put into a 200 mL 4-neck flask under an Ar atmosphere and sufficiently mixed. This liquid mixture was cooled to 10°C and then trimethyl(3-sec-butyl-2,4-cyclopentadien-1-yl)silane was added dropwise to the stirring liquid mixture. After stirring at room temperature overnight, the solvent was removed in an oil bath at 70°C under a reduced pressure. The flask containing the produced titanium complex was connected to a distillation and purification apparatus, distillation and purification were performed in an oil bath at 145°C and 11 Pa, and thereby 9.07 g of Compound No. 5 as a red-orange liquid was obtained.

### (Analytical Data)

(1) Atmospheric pressure TG-DTA (quartz pan)
   Temperature of 50% mass reduction: 246°C (Ar flow rate: 100 mL/min, temperature increase rate: 10°C/min, sample amount: 10.172 mg)
(2) Reduced pressure TG-DTA (quartz pan)
   Temperature of 50% mass reduction: 157°C (Ar flow rate: 50 mL/min, temperature increase rate: 10°C/min, sample amount: 10.404 mg)
(3) 1H-NMR (C6D6)
   0.552 ppm (t, 3 H), 0.936 ppm (d, 3 H), 1.061 ppm (m, 1 H), 1.264 ppm (m, 1 H), 2.717 ppm (m, 1 H), 5.962 ppm (m, 1 H), 6.026 ppm (m, 1 H), 6.141 ppm (m, 2 H)
(4) Elemental analysis (metal analysis: ICP-AES, CHN analysis: CHN analyzing device, chlorine analysis: TOX analyzing device)
   Ti: 17.2 mass%, C: 39.3 mass%, H: 4.6 mass%, Cl: 38.2 mass% (theoretical values; Ti: 17.38 mass%, C: 39.25 mass%, H: 4.76mass%, Cl: 38.61 mass%)

### [Example 1] Synthesis of Compound No. 8

3.00 g of titanium tetrabromide and 30.00 g of dehydrated toluene were put into a 100 mL 3-neck flask under an Ar atmosphere and sufficiently mixed. This liquid mixture was cooled to 10°C and then trimethyl(3-ethyl-2,4-cyclopentadien-1-yl)silane was added dropwise to the stirring liquid mixture. After stirring at room temperature overnight, the solvent was removed in an oil bath at 75°C under a reduced pressure. The flask containing the produced titanium complex was connected to a distillation and purification apparatus, distillation and purification were performed, and thereby Compound No. 8 as a red solid was obtained. The melting point of the compound was 70°C.

### (Analytical Data)

(1) Atmospheric pressure TG-DTA (quartz pan)
   Temperature of 50% mass reduction: 261°C (Ar flow rate: 100 mL/min, temperature increase rate: 10°C/min, sample amount: 9.877 mg)
(2) Reduced pressure TG-DTA (quartz pan)
   Temperature of 50% mass reduction: 168°C (Ar flow rate: 50 mL/min, temperature increase rate: 10°C/min, sample amount: 10.192 mg)
(3) 1H-NMR (C6D6)
   0.784 ppm (t, 3 H), 2.283 ppm (q, 2 H), 6.081 ppm (m, 4 H)
(4) Elemental analysis (metal analysis: ICP-AES, CHN analysis: CHN analyzing device, bromine analysis: TOX analyzing device)
   Ti: 12.5 mass%, C: 22.1 mass%, H: 2.5 mass%, Br: 62.6 mass% (theoretical values; Ti: 12.57 mass%, C: 22.08 mass%, H: 2.38 mass%, Br: 62.96 mass%)

### [Example 2] Synthesis of Compound No. 10

3.00 g of titanium tetrabromide and 30.00 g of dehydrated toluene were put into a 100 mL 3-neck flask under an Ar atmosphere and sufficiently mixed. This liquid mixture was cooled to 10°C and then trimethyl(3-butyl-2,4-cyclopentadien-1-yl)silane was added dropwise to the stirring liquid mixture. After stirring at room temperature overnight, the solvent was removed in an oil bath at 75°C under a reduced pressure. The flask containing the produced titanium complex was connected to a distillation and purification apparatus, distillation and purification were performed, and thereby Compound No. 10 as a red solid was obtained. The melting point of the compound was 51°C.

### (Analytical Data)

(1) Atmospheric pressure TG-DTA (aluminum pan)
   Temperature of 50% mass reduction: 280°C (Ar flow rate: 100 mL/min, temperature increase rate: 10°C/min, sample amount: 10.368 mg)
(2) Reduced pressure TG-DTA (aluminum pan)
   Temperature of 50% mass reduction: 171°C (Ar flow rate: 50 mL/min, temperature increase rate: 10°C/min, sample amount: 10.005 mg)
(3) 1H-NMR (C6D6)
   0.737 ppm (t, 3 H), 1.013 ppm (m, 2 H), 1.177 ppm (m, 2 H), 2.376 ppm (t, 2 H), 6.146 ppm (m, 4 H)
(4) Elemental analysis (metal analysis: ICP-AES, CHN analysis: CHN analyzing device, bromine analysis: TOX analyzing device)
   Ti: 11.4 mass%, C: 26.5 mass%, H: 3.0 mass%, Br: 58.6 mass% (theoretical values; Ti: 11.71 mass%, C: 26.44 mass%, H: 3.21 mass%, Br: 58.64 mass%)

### [Evaluation Example 1] Evaluation of pyrophoricity

It was checked whether pyrophoricity was exhibited when Compounds Nos. 3, 4, 5, 8, and 10 were left in air. The results are shown in Table 1.

**Table 1**

| Compound | Pyrophoricity |
|---|---|
| Compound No. 3 | None |
| Compound No. 4 | None |
| Compound No. 5 | None |
| Compound No. 8 | None |
| Compound No. 10 | None |

Based on the results of Table 1, it was found that Compounds Nos. 3, 4, 5, 8, and 10 did not exhibit pyrophoricity, and were able to be safely used in air as raw materials for chemical vapor deposition.

### [Evaluation Example 2] Evaluation of melting point

Regarding Compounds Nos. 3, 4, 5, 8, and 10 and the following Comparative Compounds 1, 2, 3, and 4, states of the compounds were visually observed at 30°C under atmospheric pressure, and the melting point of the solid compound was measured using a micro melting point measuring device. The results are shown in Table 2. Here, in the following Comparative Compounds 1 to 4, "Me" represents a methyl group.

**Table 2**

| | Compound | State | Melting point/°C |
|---|---|---|---|
| Comparative Example 1 | Comparative Compound 1 | Solid | 232 |
| Comparative Example 2 | Comparative Compound 2 | Solid | 90 |
| Comparative Example 3 | Comparative Compound 3 | Solid | 271 |
| Comparative Example 4 | Comparative Compound 4 | Solid | 100 |
| Evaluation Example 2-1 | Compound No. 3 | Solid | 49 |
| Evaluation Example 2-2 | Compound No. 4 | Liquid | - |
| Evaluation Example 2-3 | Compound No. 5 | Liquid | - |
| Evaluation Example 2-4 | Compound No. 8 | Solid | 70 |
| Evaluation Example 2-5 | Compound No. 1 0 | Solid | 51 |

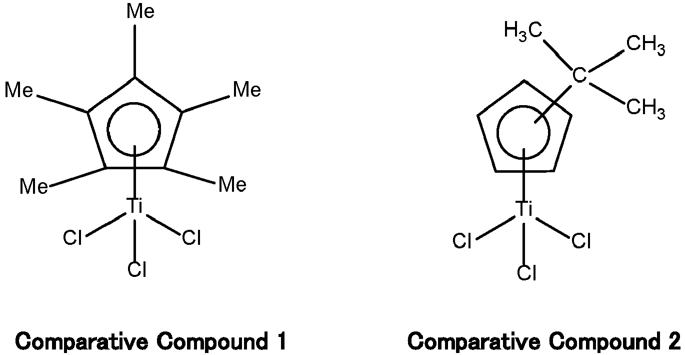

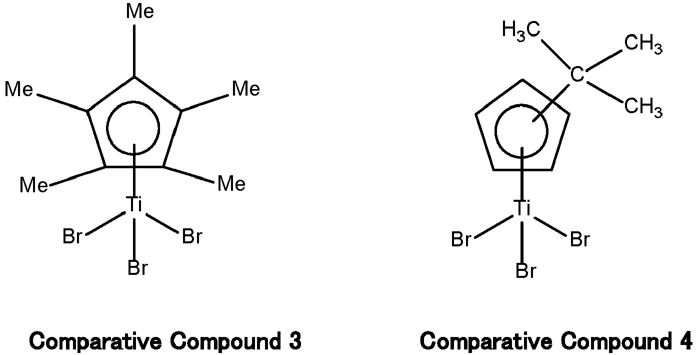

Based on the results of Table 2, it was found that Compounds Nos. 3, 4, 5, 8, and 10 had a lower melting point than Comparative Compounds 1 to 4. It was found that, among these, Compounds Nos. 3, 4, 5 and 10 had a low melting point, and Compounds Nos. 4 and 5 had a particularly low melting point and were excellent. A trend in the melting points obtained from the results in Table 2 was opposite to that of the findings obtained in the above PTL 3, and it was confirmed that the melting point of a compound in which an alkyl group was a bulky tertiary butyl group was higher than a compound in which a butyl group bonded to a cyclopentadienyl group was an n-butyl group (Compound No. 4) or a secondary butyl group (Compound No. 5) .

### [Example 3] Manufacture of titanium carbide thin film

Compound No. 3 was used as a raw material for an ALD method, and a titanium carbide thin film was manufactured on a silicon wafer using the apparatus shown in Fig. 3 by the ALD method under the following conditions. The film thickness of the obtained thin film was measured according to an X-ray reflectance method, and the thin film structure and the thin film composition were checked using an X-ray diffraction method and X-ray photoelectron spectroscopy. The film thickness was 7.6 nm, the film composition was a titanium carbide thin film, and the carbon content was 51 atom% (theoretical amount of 50 atom%). The residual carbon components as organic substances were not detected. The film thickness obtained for one cycle was 0.15 nm.

### (Conditions) Reaction temperature (substrate temperature): 250°C, reactive gas: hydrogen

### (steps) A series of steps including the following (1) to (4) was set as one cycle and repeated over 50 cycles.

(1) Vapor of a raw material for chemical vapor deposition vaporized under conditions of a raw material container temperature of 90°C and a raw material container pressure of 0.8 Torr (106 Pa) was introduced into a film formation chamber, and deposition was performed on a surface of a silicon wafer at a system pressure of 0.6 Torr (80 Pa) for 10 seconds.
(2) Purging with argon gas was performed for 20 seconds, and thereby unreacted raw materials were removed.
(3) A reactive gas was introduced and reacted at a system pressure of 0.6 Torr (80 Pa) for 10 seconds. In this case, a high frequency output with 13.56 MHz and 100 W was applied to the reactive gas so that it became a plasma.
(4) Purging with argon gas was performed for 15 seconds, and thereby unreacted raw materials were removed.

### [Example 4] Manufacture of titanium carbide thin film

A titanium carbide thin film was produced under the same conditions as in Example 3 except that Compound No. 4 was used as a raw material for an ALD method.

The film thickness of the obtained thin film was measured according to an X-ray reflectance method, and the thin film structure and the thin film composition were checked using an X-ray diffraction method and X-ray photoelectron spectroscopy. The film thickness was 7.5 nm, the film composition was a titanium carbide thin film, and the carbon content was 52 atom% (theoretical amount of 50 atom%). Residual carbon components as organic substances were not detected. The film thickness obtained for one cycle was 0.15 nm.

### [Example 5] Manufacture of titanium carbide thin film

A titanium carbide thin film was manufactured under the same conditions as in Example 3 except that Compound No. 5 was used as a raw material for an ALD method.

The film thickness of the obtained thin film was measured according to an X-ray reflectance method, and the thin film structure and the thin film composition were checked using an X-ray diffraction method and X-ray photoelectron spectroscopy. The film thickness was 7.8 nm, the film composition was a titanium carbide thin film, and the carbon content was 52 atom% (theoretical amount of 50 atom%). Residual carbon components as organic substances were not detected. The film thickness obtained for one cycle was 0.16 nm.

### [Example 6] Manufacture of titanium carbide thin film

A titanium carbide thin film was manufactured under the same conditions as in Example 3 except that Compound No. 8 was used as a raw material for an ALD method.

The film thickness of the obtained thin film was measured according to an X-ray reflectance method, and the thin film structure and the thin film composition were checked using an X-ray diffraction method and X-ray photoelectron spectroscopy. The film thickness was 7.2 nm, the film composition was a titanium carbide thin film, and the carbon content was 50 atom% (theoretical amount of 50 atom%). Residual carbon components as organic substances were not detected. The film thickness obtained for one cycle was 0.14 nm.

### [Example 7] Manufacture of titanium carbide thin film

A titanium carbide thin film was manufactured under the same conditions as in Example 3 except that Compound No. 10 was used as a raw material for an ALD method.

The film thickness of the obtained thin film was measured according to an X-ray reflectance method, and the thin film structure and the thin film composition were checked using an X-ray diffraction method and X-ray photoelectron spectroscopy. The film thickness was 7.0 nm, the film composition was a titanium carbide thin film, and the carbon content was 51 atom% (theoretical amount of 50 atom%). Residual carbon components as organic substances were not detected. The film thickness obtained for one cycle was 0.14 nm.

### [Comparative Example 1] Manufacture of titanium carbide thin film

A titanium carbide thin film was manufactured under the same conditions as in Example 1 except that tetrakis neopentyl titanium was used as a raw material for an ALD method.

The film thickness of the obtained thin film was measured according to an X-ray reflectance method, and the thin film structure and the thin film composition were checked using an X-ray diffraction method and X-ray photoelectron spectroscopy. The film thickness was 1.0 nm, the film composition was titanium carbide, and the carbon content was 40 atom% (theoretical amount of 50 atom%) . 10 atom% or more of residual carbon components as organic substances were detected. The film thickness obtained for one cycle was 0.12 nm.

Based on the results of Examples 1 to 4, when the raw materials for thin film formation of the present invention were used, it was possible to form a high quality titanium carbide thin film containing a very small amount of the residual carbon components as organic substances and containing an amount of a carbon component close to a theoretical amount. On the other hand, it was found that, in Comparative Example 1, a large amount of the residual carbon components as organic substances were mixed into the thin film, and a poor quality titanium carbide thin film having a carbon content smaller than the theoretical amount was obtained.

## Claims

1. Use of a raw material for thin film formation containing a compound represented by General Formula (1): 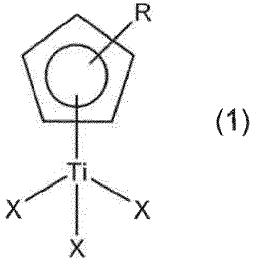 wherein, X represents a halogen atom, and R represents a primary alkyl group having 1 to 5 carbon atoms or a secondary butyl group.

2. The use according to claim 1, wherein X is a chlorine atom or a bromine atom.

3. The use according to claim 1 or 2, wherein X is a chlorine atom, and R is a primary alkyl group having 3 to 5 carbon atoms or a secondary butyl group.

4. The use according to claim 1 or 2, wherein X is a bromine atom, and R is a primary alkyl group having 2 to 4 carbon atoms or a secondary butyl group.

5. A method for manufacturing titanium-atom-containing thin film, comprising:
vaporizing the raw material for thin film formation as defined in any one of claims 1 to 4;
introducing the resulting vapor containing the compound represented by General Formula (1) into a treatment atmosphere; and
decomposing and/or chemically reacting the compound and performing deposition on a surface of a substrate.

6. A compound represented by the following General Formula (2): 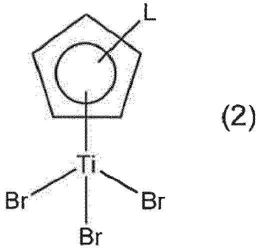 wherein, L represents a primary alkyl group having 2 to 5 carbon atoms or a secondary butyl group.

7. The compound according to claim 6, wherein L is an ethyl group.

## Patentansprüche

1. Verwendung eines Rohmaterials zur Bildung einer Dünnschicht, bestehend aus einer Verbindung, dargestellt durch die Allgemeine Formel (1): 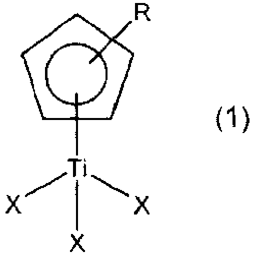 wobei X ein Halogenatom darstellt und R eine primäre Alkylgruppe mit 1 bis 5 Kohlenstoffatomen oder eine sekundäre Butylgruppe darstellt.

2. Verwendung nach Anspruch 1, wobei X ein Chloratom oder ein Bromatom ist.

3. Verwendung nach Anspruch 1 oder 2, wobei X ein Chloratom ist und R eine primäre Alkylgruppe mit 3 bis 5 Kohlenstoffatomen oder eine sekundäre Butylgruppe ist.

4. Verwendung nach Anspruch 1 oder 2, wobei X ein Bromatom ist und R eine primäre Alkylgruppe mit 2 bis 4 Kohlenstoffatomen oder eine sekundäre Butylgruppe ist.

5. Verfahren zum Herstellen einer titanatomhaltigen Dünnschicht, umfassend:
Verdampfen eines Rohmaterials zur Bildung einer Dünnschicht, wie in einem der Ansprüche 1 bis 4 definiert;
Einführen des resultierenden Dampfes, der die durch die Allgemeine Formel (1) dargestellte Verbindung enthält, in eine Behandlungsatmosphäre; und
Zersetzen und/oder chemisches Umsetzen der Verbindung und Durchführen einer Abscheidung auf einer Oberfläche eines Substrats.

6. Verbindung, dargestellt durch die Allgemeine Formel (2): 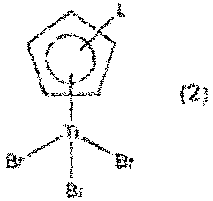 wobei L eine primäre Alkylgruppe mit 2 bis 5 Kohlenstoffatomen oder eine sekundäre Butylgruppe darstellt.

7. Verbindung nach Anspruch 6, wobei L eine Ethylgruppe ist.

## Revendications

1. Utilisation d'une matière première pour la formation d'un film mince contenant un composé représenté par la Formule Générale (1) : 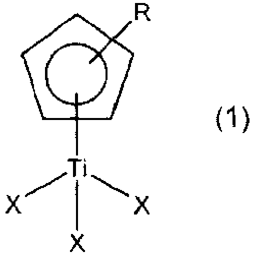 dans laquelle, X représente un atome d'halogène, et R représente un groupe alkyle primaire ayant 1 à 5 atomes de carbone ou un groupe butyle secondaire.

2. Utilisation selon la revendication 1, dans laquelle X est un atome de chlore ou un atome de brome.

3. Utilisation selon la revendication 1 ou 2, dans laquelle X est un atome de chlore, et R est un groupe alkyle primaire ayant 3 à 5 atomes de carbone ou un groupe butyle secondaire.

4. Utilisation selon la revendication 1 ou 2, dans laquelle X est un atome de brome, et R est un groupe alkyle primaire ayant 2 à 4 atomes de carbone ou un groupe butyle secondaire.

5. Procédé de fabrication d'un film mince contenant des atomes de titane, comprenant :
la vaporisation de la matière première pour la formation d'un film mince telle que définie dans l'une quelconque des revendications 1 à 4 ;
l'introduction de la vapeur résultante contenant le composé représenté par la Formule Générale (1) dans une atmosphère de traitement ; et
la décomposition et/ou la mise en réaction chimique du composé et la réalisation d'un dépôt sur une surface d'un substrat.

6. Composé représenté par la Formule Générale (2) suivante : 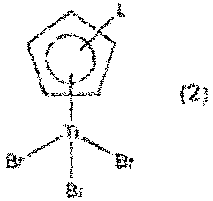 dans laquelle, L représente un groupe alkyle primaire ayant 2 à 5 atomes de carbone ou un groupe butyle secondaire.

7. Composé selon la revendication 6, dans lequel L est un groupe éthyle.
